# EUROPEAN PATENT APPLICATION

(11) **EP 4 166 333 A1**
(43) Date of publication of application: **19.04.2023**
(21) Application number: 20940681.8
(22) Date of filing: 15.06.2020
(51) Int. Cl.: B41F 15/08

(54) **SOLDER PRINTING MACHINE**

(71) Applicant: Fuji Corporation, Chiryu-shi, Aichi 472-8686 (JP)
(72) Inventor: FUKAKUSA, Shoji, Chiryu-shi Aichi 472-8686 (JP)
(74) Representative: Grünecker Patent- und Rechtsanwälte PartG mbB
(86) International application number: PCT/JP2020/023380
(87) International publication number: WO 2021/255782

(57) **Abstract**

A solder printing machine, which is configured to print paste-state solder on a board by use of a mask and a squeegee configured to move on an upper surface of the mask, includes a bed, a mask frame fixedly provided on the bed and configured to hold the mask, and a squeegee frame fixedly provided on the bed, formed separately from the mask frame, and configured to support a driving mechanism configured to drive the squeegee.

## Description

### Technical Field

The present description relates to a solder printing machine for printing paste-state solder on a board using a mask and a squeegee.

### Background Art

There have been spreading techniques for mass-producing board products by performing board work on a board on which printed wiring is laid. Further, it is a common technique to make up a board working line by arranging in a row a solder printing machine, a component mounter, a reflow machine, a board inspection machine, and the like which each execute a corresponding piece of board work. The solder printing machine prints paste-state solder on a board using a mask and a squeegee. In order to maintain the printing quality of the solder printing machine in good conditions, it is important to make the position of a mask with respect to a board stable. Patent Literature 1 discloses one technical example relating to this type of solder printing machine.

A printing device of Patent Literature 1 includes a mask lifting and lowering mechanism section configured to position a mask with respect to a board by lifting or lowering the mask with respect to the board, a frame structure body which is placed so as to be independent of lifting and lowering operations of the mask, and a printing mechanism section provided movably on the frame structure body and including a print load unit. With this printing device, it is said that the occurrence of a situation in which the mask is inclined in an up-down direction can be suppressed to thereby suppress the influence on the height position accuracy of the mask.

### Patent Literature

Patent Literature 1: JP-A-2012-240225

### Summary of the Invention

### Technical Problem

Incidentally, the printing device of Patent Literature 1 is preferable in that the occurrence of the situation in which the mask is inclined in the up-down direction is suppressed; however, with the printing device, it is difficult to make a horizontal position of the mask stable. To describe this in details, the print load unit of the printing mechanism section is driven by a horizontal positioning mechanism to move together with the mask lifting and lowering mechanism section in the horizontal direction. Specifically speaking, the frame structure body, moving in the horizontal direction, has a rectangular frame shape, the mask lifting and lowering mechanism section is disposed inside the frame shape of the frame structure body, and the printing mechanism section is disposed on a top plate section making up the frame shape. As a result, the influence of vibrations associated with the operation of the print load unit is transmitted to the mask lifting and lowering mechanism section by way of the frame structure body. As a result, the registration precision of the mask with respect to the board is reduced, or the printing quality of solder is reduced.

Therefore, an object of the present description is to solve a problem of how to provide a solder printing machine which can maintain the registration precision and the solder printing quality thereof in good conditions by suppressing the influence of vibrations associated with the operation of a squeegee on a mask position.

### Solution to Problem

The present description discloses a solder printing machine configured to print paste-state solder on a board by use of a mask and a squeegee configured to move on an upper surface of the mask, the solder printing machine including a bed, a mask frame fixedly provided on the bed and configured to hold the mask, and a squeegee frame fixedly provided on the bed, formed separately from the mask frame, and configured to support a driving mechanism configured to drive the squeegee.

### Advantageous Effect of the Invention

In the solder printing machine disclosed by the present description, the bed, the mask frame, and the squeegee frame are each made up of a separate member. As a result, vibrations generated when the squeegee operates are transmitted sequentially to the squeegee frame, the bed, and the mask frame in that order, and arrives at the mask after the vibrations are attenuated largely. Consequently, the influence of vibrations associated with the operation of the squeegee to the mask position is suppressed largely, whereby the registration precision and the solder printing quality are maintained in good conditions.

### Brief Description of Drawings

[Fig. 1] Fig. 1 is a perspective view of a solder printing machine according to an embodiment.
[Fig. 2] Fig. 2 is a right side view showing a mask frame of the solder printing machine.
[Fig. 3] Fig. 3 is a right side view showing a squeegee frame of the solder printing machine.
[Fig. 4] Fig. 4 is a right side view showing a cover frame of the solder printing machine.
[Fig. 5] Fig. 5 is a plan view schematically showing a positional relationship among a board, a mask, and a squeegee of the soldering printing machine of the embodiment.
[Fig. 6] Fig. 6 is a plan view schematically showing a positional relationship among a board, a mask, and a squeegee of a soldering printing machine of the related art.

### Description of Embodiments

### 1. Overall Configuration of Solder Printing Machine 1 of Embodiment

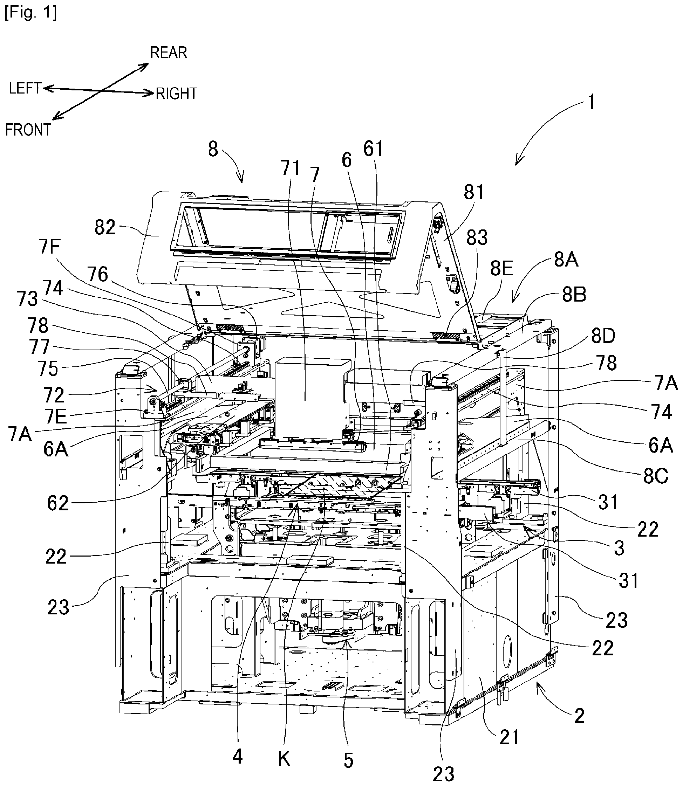

Referring to Fig. 1, an overall configuration of solder printing machine 1 according to an embodiment will be described. Solder printing machine 1 prints paste-state solder on board K using mask 6 and squeegee 7. In Fig. 1, board K is shown as hatched with dashed lines as a matter of convenience. In addition to mask 6 and squeegee 7, solder printing machine 1 is made up of bed 2, board conveyance device 3, clamp mechanism 4, lifting and lowering mechanism 5, cover 8, and the like. Front, rear, left and right of solder printing machine 1 are defined as indicated by arrows shown in a top left corner portion of Fig. 1. A front-rear direction is a movement direction of squeegee 7, and a direction from the left to the right is a conveyance direction of board K.

Bed 2 is a section referred to as a base table or a base and can be regarded as an unmoving body which is fixed to a floor. Various types of devices and mechanisms, which will be described later, are assembled to bed 2. Bed 2 is formed sturdy and has a high rigidity. Bed 2 is made up of multiple members, which will be described later.

Board conveyance device 3 is disposed at substantially a middle height of bed 2. Board conveyance device 3 not only conveys board K to a position directly below a printing execution position but also conveys out relevant board K on which printing has been executed. Board conveyance device 3 includes pair of guide rails 31, a pair of conveyor belts, a belt driving section, and the like. Pair of guide rails 31 extend in a left-right direction in parallel with each other while being spaced apart from each other. The printing execution position is set around a center defined between guide rails 31 in the left-right direction. The pair of conveyor belts are disposed at an upper portion lying between inner sides of pair guide rails 31 which face each other. The pair of conveyor belts rotate with board K placed on conveyor conveyance surfaces thereof. The belt driving section drives the pair of conveyor belts to rotate.

Clamp mechanism 4 clamps and positions board K. Clamp mechanism 4 is made up of a pair of clamp plates, a backup table, multiple backup pins, a clamping motor, a lifting and lowering motor, and the like. The pair of clamp plates are disposed above pair of guide rails 31, and either of the pair of clamp plates and pair of guide rails 31 is made to move. Here, only the clamp plates may be made to move, or both the clamp plates and guide rails 31 may be made to move. The clamp plates may each have a flange portion for pressing against an upper surface of board K.

The backup table is disposed between pair of guide rails 31. Multiple backup pins are disposed in such a manner as stand on an upper surface of the backup table so as to push up a lower surface of board K. The clamping motor narrows a separation distance defined between the pair of clamp plates so as to clamp board K in the horizontal direction between the clamp plates. The lifting and lowering motor drives and lifts up the backup table and the backup pins so as to clamp board K in a vertical direction between the flange portions of the clamp plates and the backup pins.

Lifting and lowering mechanism 5 lifts up board K together with board conveyance device 3 and clamp mechanism 4 so as to position relevant board K at the height of the printing execution position. Lifting and lowering mechanism 5 is made up of a lifting and lowering base, the lifting and lowering motor, and the like. The lifting and lowering base supports board conveyance device 3 and clamp mechanism 4. The lifting and lowering motor is fixed to bed 2 and drives to lift up or lower the lifting and lowering base via a ball screw feed mechanism. The upper face of board K comes into contact with a lower surface of mask 6 as a result of the lifting and lowering base being so lifted up. Here, the applicant of the present patent application discloses a detailed configuration example of clamp mechanism 4 and lifting and lowering mechanism 5 in WO 2017/145280.

Mask 6 is a die plate for printing solder paste on a land (an electrode) formed on an upper surface of board K. Therefore, mask 6 differs to match a type of board K. Mask 6 has a rectangular sheet shape which is larger one size than board K and has print holes which are arranged so as to match an arrangement of lands on board K. Mask 6 is held in mask frame 61 having a rectangular frame shape and extends in the horizontal direction.

Mask frame 61 holds multiple types of masks 6 in such a manner as to be exchanged. Mask frame 61 is disposed above board conveyance device 3 and clamp mechanism 4. Mask frame 61 is such that positions in two horizontal directions and a rotation angle within a horizontal plane are corrected by position correction mechanisms 62. This enables a positional registration (a die plate registration) of mask 6 with respect to board K as a base. Position correction mechanisms 62 are individually supported by pair of left and right mask frames 6A. Mask frames 6A are fixedly provided on bed 2.

Pair of squeegees 7, which are substantially symmetrical in the front-rear direction, are disposed above mask 6. Pair of squeegees 7 are supported below squeegee head 71 in such a manner as to be lifted up and lowered. One of pair of squeegees 7 lowers in accordance with a movement direction of squeegee head 71. Squeegee 7 which lowers so moves over the upper surface of mask 6 to thereby move solder paste for execution of a printing operation. Squeegee head 71 is driven in the front-rear direction by drive mechanism 72.

Drive mechanism 72 is made up of moving body 73, pair of left and right guide sections 74, screw shaft 75, drive motor 76, ball nut 77, and the like. Moving body 73 is a thin elongated member extending in the left-right direction. Squeegee head 71 is fixed to substantially a center of moving body 73. Moving body 73 has pair of rod-shaped support members 78 each protruding in the left-right direction on a front surface side thereof. Lower portions of distal end portions of pair of support members 78 so protruding are individually mounted on corresponding guide sections 74 in such a manner as to move thereon.

Pair of left and right guide sections 74 extend in the front-rear direction. Pair of left and right guide sections 74 guide moving body 73 in the front-rear direction. Screw shaft 75 is disposed parallel to left guide section 74 while being spaced apart upwards from left guide section 74. Drive motor 76 is fixedly disposed to the rear of screw shaft 75. Drive motor 76 drives to rotate screw shaft 75 about an axis thereof.

Further, ball nut 77 is provided on an upper portion of the distal end of left support member 78 of moving body 73. Ball nut 77 is brought into screw engagement with screw shaft 75 to make up the ball screw feed mechanism. When drive motor 76 drives to rotate screw shaft 75, ball nut 77 moves forwards and backwards with respect to screw shaft 75. As a result, moving body 73 and squeegee head 71 move in the front-rear direction. Drive mechanism 72 is supported by pair of left and right squeegee frames 7A. Pair of squeegee frames 7A are fixedly provided on bed 2.

Cover 8 is provided not only to protect an inside of solder printing machine 1 but also to secure the safety of an operator. Cover 8 is formed by a continuous connection of upper surface portion 81 with front surface portion 82 and has an L-shape in side view. Upper surface portion 81 covers substantially a front half of an upper surface of solder printing machine 1. Front surface portion 82 covers a part of an upper portion of a front surface of solder printing machine 1. Two hinges 83 are provided on a rear edge of upper surface portion 81 in such a manner as to be spaced apart in the left-right direction. Cover 8 is designed to open and close as cover 8 operates to rotate about these hinges 83, and the operator operates relevant cover 8 to open and close.

A part of each of upper surface portion 81 and front surface portion 82 is formed of transparent resin or glass so that the inside of solder printing machine 1 can be seen from the outside. When movable sections such as board conveyance device 3, squeegee 7, and the like operate with cover 8 kept open, the safety is reduced. To cope with this problem, a safety device, whose illustration is omitted, is provided so as to restrict the operation of the movable sections with cover 8 kept opened. Hinges 83 of cover 8 are supported by cover frame 8A. Cover frame 8A is fixedly provided on bed 2.

### 2. Detailed Structures of Bed 2 and Three Frames

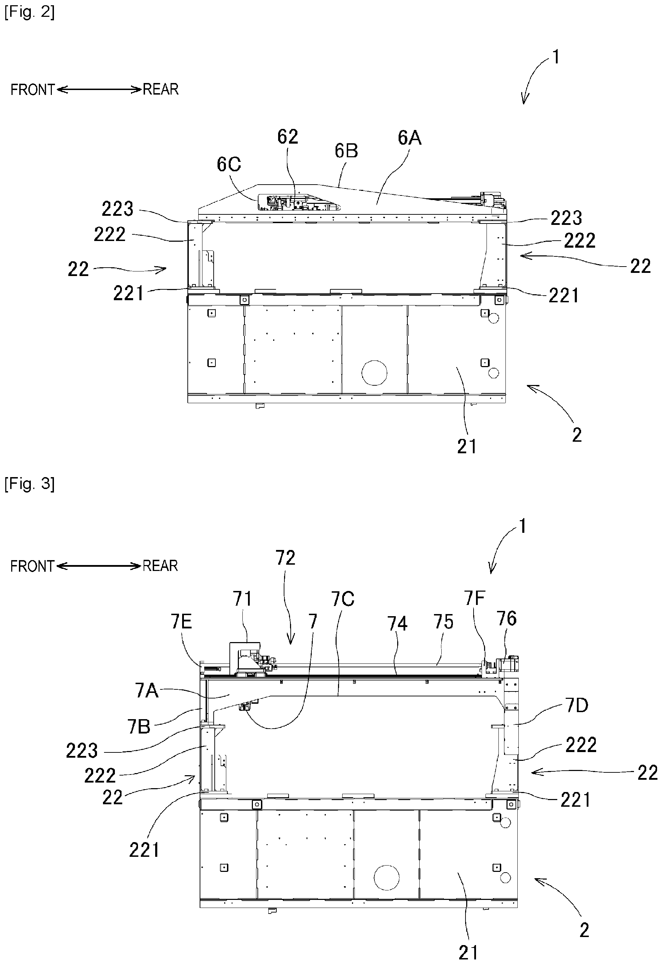

Subsequently, referring to Figs. 2 to 4 in addition to Fig. 1, detailed structures of bed 2 and the three frames will be described. In the present embodiment, mask frame 6A, squeegee frame 7A, and cover frame 8A are made up of members which are different from one another. Further, the three frames are formed as separate bodies from bed 2.

Bed 2 is made up of bed main body 21, four inner support columns 22, and four outer support columns 23. Bed main body 21 has a substantially rectangular parallelepiped box shape or frame shape and makes up a lower part of bed 2. Bed main body 21 is formed sturdy using a shape steel, a steel plate, or the like. As a result, bed 2 is given a high rigidity and hardly vibrates.

Inner support columns 22 are individually disposed at four corners of an upper surface of bed main body 21 in such a manner as to stand upright therefrom. Inner support columns 22 are each formed of a combination of a shape steel and a thick steel plate. As shown in Figs. 2 and 3, inner support columns 22 are each made up of bottom portion 221, perpendicular portion 222, and top portion 223. Bottom portion 221 has a substantially rectangular plate shape and is disposed horizontally. Bottom portion 221 is fixed to the upper surface of bed main body 21 using bolts. Perpendicular portion 222 is fixed to bottom portion 221 and extends vertically upwards. Top portion 223 is fixed to an upper surface of perpendicular portion 222, has a substantially rectangular plate shape, and is disposed horizontally. Mask frames 6A and squeegee frames 7A are fixedly attached to an upper surface of top portion 223.

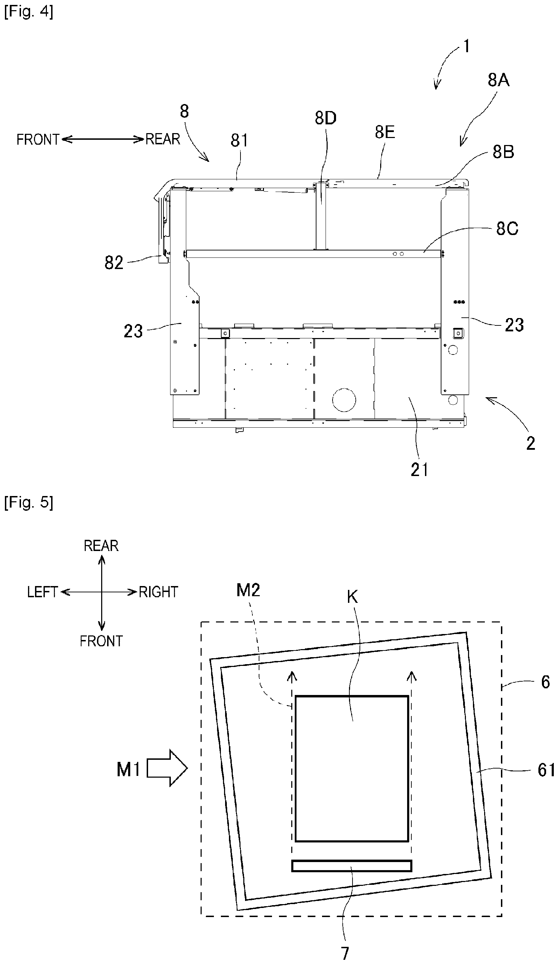

Outer support columns 23 extend upwards from four corners of bed main body 21. Outer support columns 23 each have substantially an L-shape in plan view and are each slightly rounded at a bent portion. Outer support columns 23 are each fixed to two adjacent side surfaces of bed main body 21 with fixing screws. Outer support columns 23 are individually positioned outwards of corresponding inner support columns 22 and each extend upwards further than corresponding inner support columns 22. As shown in Fig. 4, cover frame 8A is fixedly attached closer to upper portions of outer support columns 23.

Mask frame 6A is formed mainly of a plate material extending in the front-rear direction. Mask frame 6A directly supports corresponding position correction mechanism 62 and indirectly supports mask frame 61 and mask 6. As shown in Fig. 2, in mask frame 6A, upper edge 6B thereof has an angular protuberant shape in side view, and cut-out window 6C is formed in a center thereof. Pair of left and right mask frames 6A support individually corresponding position correction mechanism 62 on inner sides thereof which face each other. Each of mask frames 6A spans between and is fixed to top portions 223 of front and rear inner support columns 22. A rigidity at least in the front-rear direction (the movement direction of squeegee 7) of mask frame 6A is smaller than the rigidity of bed 2.

Squeegee frames 7A are each formed mainly of a member extending in the front-rear direction. Squeegee frames 7A support drive mechanism 72 for driving squeegee 7. To describe this in detail, pair of left and right squeegee frames 7A support individually corresponding guide section 74 on an upper surface thereof. As shown in Figs. 1 and 3, front metal fixture 7E is provided at a front end of an upper surface of left squeegee frame 7A, and a rear metal fixture 7F is provided closer to a rear end of the upper surface thereof. Front metal fixture 7E and rear metal fixture 7F rotatably support both ends of screw shaft 75. Further, rear metal fixture 7F supports drive motor 76 at a rear side thereof.

Squeegee frames 7A individually have fixing sections 7B which extend downwards from both front and rear ends thereof and each have a portal shape in side view. Fixing sections 7B are sections for fixing drive mechanism 72 to bed 2 at both ends thereof. Lower edge 7C of squeegee frame 7A excluding fixing section 7B is disposed at a higher position than position correction mechanism 62.

Pair of left and right squeegee frames 7A are individually disposed side by side with corresponding mask frame 6A on inner sides of pair of left and right mask frames 6A. Pair of squeegee frames 7A each span between and are individually fixed to top portions 223 of front and rear inner support columns 22, and lower ends of fixing sections 7B are individually fixed to corresponding top portions 223. Further, a rear portion of each squeegee frame 7A is fixed to corresponding inner support column 22 using attachment plate 7D. A rigidity at least in the front-rear direction (the movement direction of squeegee 7) of squeegee frame 7A is smaller than the rigidity of bed 2.

Here, each mask frame 6A holds corresponding position correction mechanism 62 inside the portal shape of corresponding squeegee frame 7A. Alternatively, pair of left and right mask frames 6A each hold corresponding position correction mechanism 62 in a central position which lies laterally inwards of the portal shape of squeegee frame 7A. By adopting such a nested structure, solder printing machine 1 can be made compact in a width dimension in the left-right direction thereof. However, a limitation is imposed on the production process, in which mask frames 6A are assembled to bed 2 earlier, and squeegee frames 7A are assembled to bed 2 later.

Cover frame 8A supports cover 8 in such a manner so as to open and close. Cover frame 8A is made up of pairs of left and right side frames 8B, left and right horizontal stays 8C, and left and right vertical stays 8D, as well as one ceiling frame 8E. Side frames 8B are each formed of a thin elongated plate member extending in the front-rear direction. Side frames 8B each span between the top portions of front and rear outer support columns 23 and are each fixed in place in a horizontal position.

With a view to increasing the rigidity of cover frame 8A, horizontal stays 8C and vertical stays 8D are provided additionally. Horizontal stays 8C are each disposed parallel to side frame 8B in a position lying below relevant side frame 8B. Horizontal stays 8C are each fixed to front and rear outer support columns 23. Vertical stays 8D each extend in the up-down direction and mechanically connect corresponding side frame 8B and horizontal stay 8C together in substantially a center position thereof.

Ceiling frame 8E spans between and is fixed to substantially rear half ranges of left and right side frames 8B. Ceiling frame 8E is formed of a plate material which is disposed horizontally, or is formed of a lattice-shaped member for weight reduction. Hinges 83 of cover 8 are connected to a front edge of ceiling frame 8E. The rigidity of cover frame 8A is smaller than the rigidity of the bed 2.

### 3. Functions and Advantageous Effects of Solder Printing Machine 1 of Embodiment

Next, functions and advantageous effects of solder printing machine 1 according to the embodiment will be described. When squeegee 7 is driven to execute a printing operation by drive mechanism 72, vibrations are generated in squeegee frames 7A. Since these vibrations are attributed to a reaction force associated with the movement of squeegee 7, these vibrations have mainly a vibration component in the front-rear direction. Vibrations in the front-rear direction of squeegee 7 are transmitted sequentially to bed 2 and mask frames 6A in that order and arrive at mask 6. Here, a rigidity in at least the front-rear direction of bed 2 is high, and hence, bed 2 hardly transmits vibrations. As a result, vibrations in the front-rear direction arrive at mask 6 while being attenuated largely, or most of the vibrations in the front-rear direction do not arrive at mask 6.

Consequently, a reduction in die plate registration precision, which would subtly change the position of mask 6 with respect to board K, is prevented from being generated in the middle of a printing operation executed by squeegee 7. In addition, the printing quality including the releasing capability of paste-state solder is prevented from being reduced. In the event that a reduction in die plate registration precision is being generated, there may be caused a case in which paste-state solder is not released completely from a printing hole in mask 6 (a deterioration of the solder releasing capability) when board K is lowered at the end of a printing operation. In this case, the periphery of the printed paste-state solder is blurred, or the position of the paste-state solder is offset from a center of a land, which will deteriorate the printing quality.

With solder printing machine 1 of the embodiment, the three constituent members, that is, bed 2, mask frame 6A, and squeegee frame 7A are made up of separate members. As a result, vibrations generated when squeegee 7 operates are transmitted sequentially to squeegee frames 7A, bed 2, and mask frames 6A in that order and arrives at mask 6 while being attenuated largely. Consequently, the influence of the vibrations caused in association with the operation of squeegee 7 on the position of mask 6 is suppressed largely, whereby the die plate registration precision and the printing quality are kept in good conditions.

Incidentally, in the configuration of the related art, mask frame 6A, squeegee frame 7A, and cover frame 8A are made up of the common member. Then, every time cover 8 is opened and closed in multiple times of opening and closing operations of cover 8, vibrations of cover frame 8A are transmitted to mask 6 and squeegee 7, and the influence of vibrations is accumulated, resulting in a possibility of occurrence of a failure. As a failure, there have been occurring some instances including, for example, a gradual increase of attachment position errors of mask 6 and squeegee 7, a generation of looseness in the attached mask 6 and squeegee 7, and the like.

In contrast to the related art configuration, with the configuration of the present embodiment, vibrations generated in association with the opening and closing operation of cover 8 arrive at mask 6 from cover frame 8A by way of bed 2 and mask frames 6A, or arrive at squeegee 7 by way of bed 2 and squeegee frames 7A. Here, bed 2 is highly rigid and hardly transmits vibrations. As a result, the influence of vibrations is hardly accumulated in mask 6 and squeegee 7, whereby a possibility of resulting in a failure is reduced.

### 4. Other Functions and Advantageous Effects of Embodiment

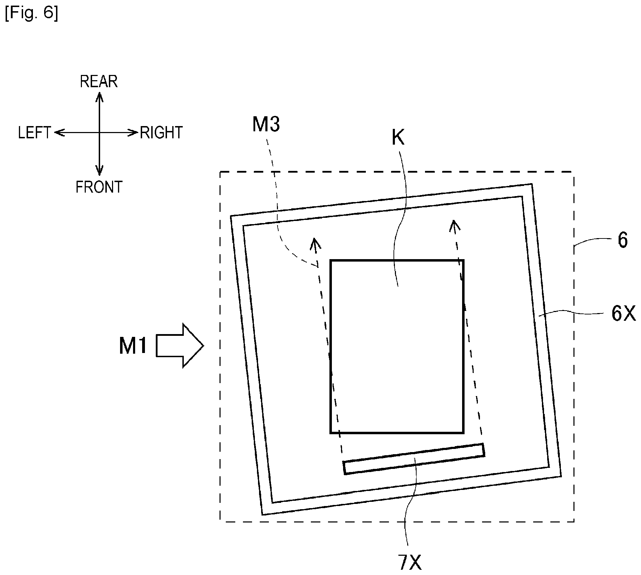

In addition, regardless of the configurations of the embodiment and the related art, there may be a case in which mask 6 is attached in such a state that four sides of mask 6 are inclined with resect to the mask frame (61, 6X) (in such a state that mask 6 is rotated in the horizontal plane, generating an angular error). As this occurs, with the embodiment, an adjustment is made so as to realize a positional relationship shown in Fig. 5, whereas with the related art, an adjustment is made so as to realize a positional relationship shown in Fig. 6. Figs. 5 and 6 are explanatory diagrams which are schematically exaggerated. In reality, the circumferential edge of mask 6 does not protrude largely from the mask frame (61, 6X).

In the embodiment shown in Fig. 5, board K is conveyed in and out in conveyance direction M1. In addition, since the squeegee frames 7A are fixed to bed 2, squeegee 7 always moves in a direction orthogonal to conveyance direction M1 of board K. On the other hand, position correction mechanisms 62 rotate mask frame 61 for correction in order to register mask 6 with board K, . As a result, mask frame 61 is corrected to a positional state in which mask frame 61 is not parallel to board K, but mask 6 is parallel to board K. At this time, squeegee 7 can move in direction M2 in which squeegee 7 is parallel to board K to thereby execute a good printing operation.

On the other hand, in the related art shown in Fig. 6, as disclosed in Patent Literature 1, for example, the mask lifting and lowering mechanism section and the printing mechanism section are disposed in the frame structure body. Then, the position of the frame structure body is corrected with respect to the position of the board in the horizontal direction and the rotation angle of the board within the horizontal plane. That is, mask frame 6X and squeegee 7X are disposed in the common frame, and the position of the common frame is corrected with respect to board K.

In the related art, when mask frame 6X is rotated in order for mask 6 to be registered with board K, squeegee 7X is also rotated together. As a result, squeegee 7X is caused to move in direction M3 which is not parallel to board K, whereby no good printing operation can be executed. In the example shown in Fig. 6, since a partial area of board K is offset from the moving range of squeegee 7X, no good printing operation is executed. In contrast to this, with the present embodiment, regardless of the rotation angles of mask 6 and mask frame 61, squeegee 7 can be caused to move in direction M2 in which squeegee 7 becomes parallel to board K at all times, thereby making it possible to execute a good printing operation.

### 5. Application and Modification of Embodiment

Here, in the present embodiment, the rigidity in at least the front-rear direction of bed 2 is described as being larger than those of mask frames 6A and squeegee frames 7A. Generally speaking, the rigidities in the three directions of a structure are interrelated. Consequently, there will be no problem even when the rigidities in the three directions of bed 2 are made larger than those of mask frames 6A and squeegee frames 7A; rather, this configuration provides a remarkable advantageous effect and facilitates a structural design.

In addition, in the embodiment, while position correction mechanisms 62 on mask frames 6A which are fixed to bed 2 are described as correcting the position and the rotation angle of mask frame 61, a different method or configuration can be adopted. For example, a configuration may be adopted in which mask frames 6A for supporting mask frame 61 are made to move relative to bed 2, and position correction mechanisms 62 which are fixed to bed 2 correct the positions of mask frames 6A. Even with this configuration, bed 2, mask frames 6A, and squeegee frames 7A can be made up of separate members, whereby similar advantageous effects to those provided by the embodiment can be provided. Other various applications and modifications can also be made to the embodiment.

### Reference Signs List

1: solder printing machine, 2: bed, 21: bed main body, 22: inner support column, 23: outer support column, 3: board conveyance device, 4: clamp mechanism, 5: lifting and lowering mechanism, 6: mask, 61, 6X: mask frame, 62: position correction mechanism, 6A: mask frame, 7, 7X: squeegee, 71: squeegee head, 72: drive mechanism, 73: moving body, 74: guide section, 75: screw shaft, 76: drive motor, 77: ball nut, 7A: squeegee frame, 7B: fixing section, 8: cover, 8A: cover frame, K: board.

## Claims

1. A solder printing machine configured to print paste-state solder on a board by use of a mask and a squeegee configured to move on an upper surface of the mask, the solder printing machine comprising:
a bed;
a mask frame fixedly provided on the bed and configured to hold the mask; and
a squeegee frame fixedly provided on the bed, formed separately from the mask frame, and configured to support a driving mechanism configured to drive the squeegee.

2. The solder printing machine according to claim 1,
wherein rigidities in a movement direction of the squeegee of the mask frame and the squeegee frame are smaller than a rigidity of the bed.

3. The solder printing machine according to claim 1 or 2,
wherein the squeegee frame has a portal shape having a pair of fixing sections configured to individually fix both ends of the drive mechanism extending in the movement direction of the squeegee to the bed, and
wherein the mask frame is disposed side by side with the squeegee frame and is configured to hold the mask in an inside of the portal shape of the squeegee frame.

4. The solder printing machine according to any one of claims 1 to 3,
wherein the mask frame supports a position correction mechanism configured to hold the mask in a position correctable manner.

5. The solder printing machine according to claim 4,
wherein the position correction mechanism corrects a position of the mask in a horizontal direction and a rotation angle of the mask in a horizontal plane, and
wherein the squeegee always moves in a certain angular direction with respect to a conveyance direction of the board.

6. The solder printing machine according to claim 5,
wherein the squeegee always moves in a direction orthogonal to the conveyance direction of the board.

7. The solder printing machine according to any one of claims 1 to 6, further comprising:
a cover frame fixedly provided on the bed, formed separately from the mask frame and the squeegee frame, and configured to hold a cover for protecting an inside of the solder printing machine in an opening and closing manner.
